# EUROPÄISCHE PATENTSCHRIFT

(11) **EP 3 720 639 B1**
(45) Veröffentlichungstag und Bekanntmachung des Hinweises auf die Patenterteilung: **01.12.2021**
(21) Anmeldenummer: 19706905.7
(22) Anmeldetag: 07.02.2019
(51) Int. Cl.: B23K 1/00, B23K 1/20

(54) **VERFAHREN ZUM HERSTELLEN EINER BAUEINHEIT SOWIE VERFAHREN ZUM VERBINDEN EINES BAUTEILS MIT EINER SOLCHEN BAUEINHEIT**
METHOD FOR PRODUCING A STRUCTURAL UNIT AND METHOD FOR CONNECTING A COMPONENT TO SUCH A STRUCTURAL UNIT
PROCÉDÉ DESTINÉ À FABRIQUER UN ENSEMBLE ET PROCÉDÉ DESTINÉ À CONNECTER UN MODULE À UN TEL ENSEMBLE

(30) Priorität: 08.02.2018 DE 102018201974
(43) Veröffentlichungstag der Anmeldung: 14.10.2020
(73) Patentinhaber: Siemens Aktiengesellschaft, 80333 München (DE)
(72) Erfinder: SCHELLENBERG, Christian, 14480 Potsdam (DE); STROGIES, Jörg, 14163 Berlin (DE)
(86) Internationale Anmeldenummer: PCT/EP2019/053030
(87) Internationale Veröffentlichungsnummer: WO 2019/154923

(56) Entgegenhaltungen:
- EP-A2- 2 490 252
- DE-A1-102015 200 991

## Beschreibung

Die Erfindung betrifft ein Verfahren zum Herstellen einer mit wenigstens einem Bauteil durch Diffusionslöten zu verlötenden und unabhängig von dem Bauteil ausgebildeten Baueinheit. Ferner betrifft die Erfindung ein Verfahren zum Verbinden eines Bauteils mit einem Substrat mittels Diffusionslöten.

Bei technischen Anwendungen wie beispielsweise dem Die-Attach, also die Bestückung von Halbleiter- und/oder Mikrosystemtechnik, sowie bei der SMD-Montage (englisch: Surface Mount Device), bei welcher oberflächenmontierte Bauteile auf Leiterplatten montiert werden, oder aber auch bei einer Kühlkörperanbindung sind zuverlässige und insbesondere hochtemperaturstabile Lötverbindungen vorteilhaft. Löten allgemein ist ein thermisches Verfahren zum stoffschlüssigen Fügen von Werkstoffen, sodass beispielsweise ein Bauteil mit einer Baueinheit verbunden werden kann. Dabei wird jeweils mittels eines an einer Oberfläche des Bauteils und der Baueinheit vorkommenden Werkstoffs sowie durch ein Lot, jeweils eine Oberflächenlegierung erzeugt, welche über eine durch das Lot gebildeten Lotschicht das Bauteil mit der Baueinheit verbindet, wodurch die stoffschlüssige Verbindung gebildet wird. Das jeweilige Werkstück, also das Bauteil beziehungsweise die Baueinheit, werden beim Löten nicht bis in eine jeweilige Tiefe aufgeschmolzen, sondern am Werkstück jeweils die genannte Oberflächenlegierung ausgebildet. Eine Möglichkeit, um die stoffschlüssige Verbindung mittels Löten herzustellen, ist das sogenannte Diffusionslöten, bei welchem während des Lotvorgangs Diffusionsprozesse ablaufen, was zu einer erweiterten Bildung der Lötverbindung führen kann. Die Lotschicht kann aus einer Lotträgerschicht gebildet sein.

Sowohl beim Die-Attach, der SMD-Montage als auch bei der Kühlkörperanbindung und darüber hinaus sind, um insbesondere Kosten zu sparen und die Umweltbelastung beispielsweise für Mitarbeiter besonders gering zu halten, insbesondere hochschmelzende Diffusionslötverbindungen gefragt, welche mit kommerziell verfügbaren, bleifreien Lotpasten, insbesondere durch das Entstehen von, insbesondere in der jeweiligen Oberflächenlegierung und dem Lot auftreten, intermetallischen Phasen, erzeugt werden können. Bei der intermetallischen Phase handelt es sich um eine homogene chemische Verbindung aus wenigstens zwei Metallen, welche eine Gitterstruktur zeigt, wobei in dem Gitter ein metallischer Verbindungsanteil überwiegt und zusätzlich Atom- beziehungsweise Ionenbindungen auftreten können.

Bei den oben genannten Anwendungsfällen kann an Stelle des Diffusionslötens eine stoffschlüssige Verbindung beispielsweise durch Silbersintern erzeugt werden. Beim Silbersintern wird sowohl das Bauteil als auch die Baueinheit, also die jeweiligen sogenannten Fügepartner, derart verbunden, dass eine erhebliche Druck- und Temperaturbelastung auf den jeweiligen Fügepartner wirkt. Ein weiterer Nachteil des Silbersinterns ist der hohe Materialpreis des Silbers selbst.

Im Stand der Technik sind ferner Diffusionslöttechnologien bekannt, welche besonders dünne Lotformteile nutzen, um Diffusionswege gering zu halten. Diese Techniken erfordern jedoch eine besonders ebene und reine Oberfläche sowohl beim Substrat, insbesondere der Baueinheit, als auch beim Bauteil. Die Verkürzung der Diffusionswege ist durch Eigenschaften bei der Handhabbarkeit der sehr dünnen Lotformteile begrenzt. Zudem ist die für ein Phasenwachstum benötigte Zeit nicht beliebig verkürzbar. Das Phasenwachstum kann beziehungsweise muss durch eine thermische Auslagerung nach dem Herstellen der Lötverbindung weiter fortgesetzt werden. Dabei ist das sogenannte Thermal-Budget des Bauteils und des Substrats zu beachten, welches jeweils einen kritischen Faktor darstellt. Einfach gesagt kann unter dem Thermal-Budget die Wärme verstanden werden, welche das Bauteil aufnehmen kann, bevor es in seiner, insbesondere zukünftigen, Funktion beeinträchtigt ist beziehungsweise wird.

Weiterhin sind Technologien mit separaten Kupferpasten und Lotpasten in der Entwicklung, bei welchen Kupferpartikel innerhalb einer Fügezone, zwischen den Fügepartner, zufällig verteilt sind, wodurch eventuell nachteilige Auswirkungen auf eine thermomechanische Zuverlässigkeit auftreten können. Ferner bedarf es bei den sich häufig noch in der Entwicklung befindenden Technologien einer Vielzahl von einzelnen Prozessen beziehungsweise Prozessschritten zur Herstellung der Verbindung. Dies wirkt sich negativ auf eine Einführung in eine Serienproduktion beziehungsweise in einen Serienprozess aus.

Vorteilhafterweise soll die Serienproduktion, insbesondere beispielsweise sowohl beim Die-Attach als auch der SMD-Montage, jedoch leicht und effizient mit bereits bestehendem Fertigungsequipment durchzuführen sein. Zusätzlich besteht bei den Verfahren des Stands der Technik die Gefahr einer Gerüstbildung, welche durch eine isotherme Erstarrung intermetallischer Phasen bereits in einem Liquidus während des Verlötens entstehen kann. Dabei werden zumindest Teile der Kupferpartikel miteinander verbunden, wodurch sogenannte geschlossene Kammern entstehen können. In diesen Kammern können sowohl organische Pastenbestandteile, beispielsweise Restbestände eines Flussmittels, als auch Gase nicht mehr entweichen und verbleiben innerhalb der Fügezone, was sich nachteilig auf die Lötverbindung, insbesondere deren mechanische und/oder thermische Stabilität, auswirken kann.

Ferner zeigt die DE 196 32 378 A1 eine Diffusionslötverbindung beziehungsweise ein Verfahren zum Herstellen von Diffusionslötverbindungen, welche sich dadurch auszeichnen, dass zwischen wenigstens zwei Verbindungspartnern eine besonders diffusionsaktive, schmelzflüssig aufgetragene und niedrigschmelzende Zwischenschicht in Form eines Lotträgers eingebracht wird. Dabei besteht der Lotträger aus einer metallenen Folie, welche beidseitig mit Lotschichten versehen ist, wobei die Lotschichten selbst wiederum aus mehreren Schichten gebildet sein können.

Zudem zeigt die US 2010/0291399 A1 für ein Verbinden eines Gehäuses und eines Deckels eines Funktionsteils, wie eine Lotpaste, die durch Mischen eines Metallpulvers auf Cu-Basis mit einer Solidustemperatur von mindestens 400° C gebildet wird, und ein Lotpulver auf Sn-Basis auf einen Deckel aus einem schwer zu lötenden Material aufgebracht werden, das zuvor einer gut lötbaren Beschichtung unterzogen und erwärmt wurde, um eine Lotschicht zu erhalten.

Schließlich zeigt die DE 10 2015 200 991 A1 ein Verfahren zum Herstellen einer Lötverbindung, bei dem auf ein Trägerelement zwei Schichten aufgebracht werden, wobei die erste Schicht zumindest Metallpartikel und Zusatzstoffe, insbesondere Flussmittel, und die zweite Schicht zumindest Lotmittel aufweist, und wobei das Trägerelement und die beiden Schichten anschließend einer Wärmebehandlung unterzogen werden, bei der die zweite Schicht verflüssigt wird und in Wirkverbindung mit der ersten Schicht gelangt. Diese Druckschrift stellt die Basis für den Oberbegriff des Anspruchs 1 dar.

Aufgabe der vorliegenden Erfindung ist es, Verfahren zu schaffen, mittels welchen Bauteile für ein Löten bereitgestellt und besonders einfach durch Löten miteinander verbunden werden können.

Diese Aufgabe wird erfindungsgemäß durch ein Verfahren gemäß dem Patentanspruch 1. Vorteilhafte Ausgestaltungen mit zweckmäßigen Weiterbildungen der Erfindung sind in den übrigen Ansprüchen angegeben.

Ein erster Aspekt der Erfindung betrifft ein Verfahren zum Herstellen einer mit wenigstens einem Bauteil durch Diffusionslöten zu verlötenden und unabhängig von dem Bauteil ausgebildeten Baueinheit. Um die Baueinheit nun besonders effizient herzustellen, weist das Verfahren mehrere Schritte auf. In einem ersten Schritt erfolgt ein Bereitstellen eines Substrats der Baueinheit. Dabei ist unter dem Substrat ein zu behandelnder Teil der Baueinheit zu verstehen, insbesondere eine aus einem Werkstoff ausgebildete Oberfläche, welche später zumindest teilweise mit Lot beziehungsweise einer Lotträgerschicht versehen wird, sodass das Bauteil dort mit der Baueinheit mittels Löten verbindbar ist. Kurz gesagt ist das Substrat eine der Oberflächen der Baueinheit, an welcher später eine Lötverbindung zu einem von dem von der Baueinheit unabhängigen Bauteil ausgebildet werden soll. In einem zweiten Schritt erfolgt ein Aufbringen einer Paste, welche zumindest Metallpartikel und von den Metallpartikeln unterschiedliche Lotpartikel aufweist, auf zumindest einem Teilbereich des Substrats mittels einer Drucktechnik. Das Merkmal, dass die Lotpartikel von den Metallpartikeln unterschiedliche Partikel sind, bedeutet, dass die Metallpartikel und die Lotpartikel zumindest teilweise aus unterschiedlichen Werkstoffen gebildet sind. Die Metallpartikel können beispielsweise aus einem elementaren Metall oder eine Metalllegierung gebildet sein.

Die auf das Substrat aufgebrachte Paste weist ferner Hohlräume auf, welche sich zwischen den jeweiligen Metallpartikeln und den jeweiligen Lotpartikeln sowie zwischen Metallpartikeln und Lotpartikeln befinden können. In einem dritten Schritt erfolgt eine Infiltration der Paste mit Lot unter Abwesenheit des Bauteils, wodurch die mit dem Lot infiltrierte Paste eine Lotträgerschicht, insbesondere auf dem Substrat der Baueinheit, bildet. Dies bedeutet, dass die Infiltration der Paste mit dem Lot unabhängig beziehungsweise separat von dem Bauteil erfolgt, das heißt ohne dass das Bauteil mit der Baueinheit verbunden wird. Mit anderen Worten unterbleibt bei der Infiltration der Paste mit dem Lot ein Verbinden beziehungsweise Verlöten des Bauteils mit der Baueinheit. Das Lot kann beispielsweise ein zinnhaltiges Lot oder ein auf Zinn-Basis ausgebildetes Lot sein. Ferner ist es möglich, dass das Lot reines Zinn ist. Die Lotpartikel der Paste können ebenfalls Zinn enthalten oder aus reinem Zinn ausgebildet sein.

Somit ist es bei dem dritten Schritt vorgesehen, dass die Paste mit dem Lot infiltriert wird, wobei beziehungsweise während ein Verbinden des Bauteils mit der Baueinheit unterbleibt. Somit wird die Baueinheit separat beziehungsweise unabhängig von dem Bauteil hergestellt, sodass das Substrat unabhängig beziehungsweise separat von dem Bauteil mit der Paste und dem Lot versehen wird. Die Lotträgerschicht kann bei einem späteren, nicht zu dem Verfahren gehörenden Verlöten der Baueinheit mit dem Bauteil eine stoffschlüssige Verbindung, insbesondere Lötverbindung, zwischen dem Bauteil und der Baueinheit ausbilden. Die Baueinheit, welche nun die Lotträgerschicht aufweist, ist in der Folge eine Art Halbzeug, das bereits das mit dem Bauteil zu verlötende und somit zu verbindende Substrat sowie eine an dem Substrat gehaltene und das Lot und die Paste umfassende sowie vorzugsweise eigensteif und trockene Verbindungseinrichtung, die Lotträgerschicht, aufweist, mittels welcher das Substrat mit dem Bauteil verbunden werden kann. Mit der durch das erfindungsgemäße Verfahren erzeugten Baueinheit kann eine Lötverbindung, insbesondere derart, ausgebildet beziehungsweise hergestellt werden, dass die Verbindungseinrichtung zumindest teilweise erwärmt und dadurch aufgeschmolzen wird, um schließlich das Bauteil mit dem Substrat zu verlöten und somit stoffschlüssig zu verbinden.

Erfindungsgemäß wird das Lot als wenigstens ein eigensteifes beziehungsweise formstabiles Formteil appliziert und/oder erfolgt mittels eines Stempels ein Anpassen der Oberflächentopographie der Paste auf dem Substrat, insbesondere in einem zusätzlichen Verfahrensschritt. Dadurch kann in besonders vorteilhafter Weise je nach beispielsweise der Form der zu bildenden Lotträgerschicht beziehungsweise Verbindungseinrichtung das Lot besonders vorteilhaft appliziert werden, sodass die anschließende Infiltration ebenfalls besonders vorteilhaft durchgeführt werden kann. Der Schritt des Anpassens der Oberflächentopographie erfolgt vor dem dritten Schritt, insbesondere jedoch nach dem zweiten Schritt. Bei dem Anpassen der Oberflächentopographie wird der dem Substrat abgewandte Oberfläche der Paste beispielsweise eine besonders ebene und somit insbesondere gleichmäßige und plane Form gegeben, welche insbesondere parallel zu der Oberfläche des Substrats und somit der Baueinheit angeordnet ist. Dadurch kann bei einem sich an das Verfahren anschließenden Lötprozess eine besonders gute Lötverbindung zwischen Bauteil und Baueinheit ausgebildet werden. Ist das Bauteil an der Seite, an welcher es mit der Lotträgerschicht verlötbar ist beispielweise nicht plan, sondern weist eine dreidimensionale Struktur auf, kann diese beim Anpassen der Oberflächentopographie beispielweise in die Lötträgerschicht eingearbeitet werden, wodurch das Bauteil beispielsweise besonders passgenau auf der Lotträgerschicht platzierbar ist.

Dabei finden der erste Schritt bis hin zum dritten Schritt vorzugsweise in einer zeitlich abgestimmten Reihenfolge statt. Der erste Schritt, das Bereitstellen des Substrats, erfolgt vor dem zweiten Schritt, dem Aufbringen der Paste. Der zweite Schritt wiederum erfolgt zeitlich vor dem dritten Schritt, der Infiltration der Paste mit dem Lot. Das erfindungsgemäße Verfahren bietet den Vorteil, die Paste mit Lot auf dem Substrat zu infiltrieren, ohne dass eine Bestückung mit dem Bauteil zu erfolgen hat. Die so geschaffene Baueinheit mit dem Substrat, welches die Lotträgerschicht aufweist beziehungsweise mit dieser verbunden ist, und nach dem dritten Verfahrensschritt einem Halbzeug gleicht, kann in besonders vorteilhafter und/oder einfacher Weise in bestehende Produktionsanlagen für Elektronik genutzt werden, ohne eine Änderung an der Produktionsanlage oder einem dort stattfindenden Diffusionslötprozesses durchzuführen. Dadurch können besonders große Investitionskosten und/oder besonders aufwendige Umbauten, insbesondere an der Produktionsanlage beziehungsweise der Fertigungslinie, insbesondere bei der Serienfertigung, entfallen. Im Gegensatz dazu wird beim bisherigen Diffusionslöten die Lotträgerschicht, welche in dem erfindungsgemäßen Verfahren eine spätere Kontaktierung des Bauteils ermöglicht, bei ihrer Erzeugung beziehungsweise Herstellung, also sprich während der Infiltration, direkt mit dem Bauteil verbunden. Dadurch ergeben sich insbesondere negative Auswirkungen auf eine Serienfertigung, da einzuhaltende Prozessabfolgen erschwert werden. Ferner kann beziehungsweise können möglicherweise in dem Lot und/oder der Paste vorhandenes Flussmittel oder vergleichbare Werkstoffe, aufgrund des auf die Lotträgerschicht aufgebrachten Bauteils, nur schwer aus der Lotträgerschicht entweichen.

Eine Idee des erfindungsgemäßen Verfahren ist, dass mittels des Verfahrens ein effizientes Erzeugen eines zum Diffusionslöten vorbereiteten Substrats beziehungsweise einer Baueinheit, welche eine Lotträgerschicht aufweist, ermöglicht wird. Ferne soll ein Verfahren zur Herstellung einer zuverlässigen, hochtemperaturstabilen, hochschmelzenden Diffusionslötverbindung bereitgestellt werden. Dabei ist ein Fokus der Erfindung, dass in dem Verfahren kommerziell verfügbare, insbesondere bleifreie, Lote verwendet werden können, und ein an der Baueinheit durchgeführter Lötvorgang in einer üblichen Fertigungslinie, insbesondere ohne Umrüstung, durchgeführt werden kann.

Für ein eventuell im Anschluss an das Verfahren folgendes Verlöten ist nun die erfindungsgemäß hergestellte Verbindungseinrichtung beziehungsweise die Lotträgerschicht derart ausgebildet, dass sie insbesondere an ihrer Oberfläche eine gewisse Restreaktivität, insbesondere des Lotes aufweist, welche für eine spätere Bauteilkontaktierung genutzt werden kann.

Ferner ergibt sich durch die Abwesenheit des Bauteils bei der Infiltration der Paste der Vorteil, dass die Infiltration wesentlich sicherer ablaufen kann. Zudem kann ein Fehlstellengehalt zwischen den Metallpartikeln untereinander beziehungsweise zueinander reduziert werden. Die Metallpartikel versuchen sich vorzugsweise zueinander in ihre Kristallstruktur auszurichten beziehungsweise sich an ihrer Kristallstruktur zu orientieren. Durch die Abwesenheit des Bauteils können sich die Metallpartikel in dem Lot beziehungsweise der Lotträgerschicht besonders flexibel anordnen, sodass unter anderem weniger Fehlstellen auftreten können.

Auch Lunker, sogenannte Voids, können durch das Fernbleiben des Bauteils in der Lotträgerschicht verkleinert beziehungsweise deren Auftreten verringert werden. Ein weiterer Vorteil ist, dass bei dem Infiltrieren ohne Bauteil das Lot in die Paste mindestens gleich effizient einzieht, insbesondere mittels Diffusion und/oder Kapillareffekten, wie bei einem angebrachten Bauteil. Darüber hinaus ist ein besonders einfaches Entgasen, insbesondere organischer Elemente beziehungsweise Verbindungen wie zum Beispiel aus einem im Lot enthaltenen Flussmittel möglich. Da die Elemente beziehungsweise Verbindungen durch die nicht umschlossene beziehungsweise abgedeckte Oberfläche des Pasten-Lot-Gemisches, und somit der sich daraus bildenden beziehungsweise ausgebildeten Lotträgerschicht, besonders vorteilhaft entweichen können. Dieser Effekt kann beispielsweise besonders vorteilhaft zusätzlich dadurch verstärkt werden, dass die Infiltration und/oder ein späterer Diffusionslötprozess beispielsweise unter Luftausschluss, insbesondere in einem Vakuum, durchgeführt werden. Kurz gesagt kann durch das erfindungsgemäße Verfahren somit besonders vorteilhaft eine Vorkonfektionierung, das heißt ein Bereitstellen, einer zum Diffusionslöten unmittelbar verwendbaren Lotträgerschicht der Baueinheit erfolgen, wobei die Baueinheit beispielsweise als Verdrahtungsträger ausgebildet ist. Durch die Vorkonfektionierung ist ein effizientes Diffusionslöten mittels der bestehenden Fertigungslinie beziehungsweise eines Fertigungsequipment realisierbar.

In vorteilhafter Ausgestaltung der Erfindung sind die Metallpartikel aus Kupfer und/oder Eisen und/oder Nickel und/oder Silber und/oder Gold gebildet. Das heißt, zumindest ein Werkstoff eines der Metallpartikel umfasst Kupfer und/oder Eisen und/oder Nickel und/oder Silber und/oder Gold. Die soeben genannten Metalle können jeweils einzeln in ihrer jeweiligen elementaren Form einen der Metallpartikel bilden. So können in der Paste ein Teil der Metallpartikel aus einem der genannten Metalle gebildet sein und ein weiterer Teil der Metallpartikel aus einem weiteren der genannten Metalle. Zusätzlich oder alternativ kann ein einzelnes der Metallpartikel aus einem oder mehreren der genannten Metalle ausgebildet sein oder aus einem anderen Metall oder einem zumindest eines der Metalle oder eine Metallverbindung aufweisenden Werkstoff gebildet sein. Beispielweise kann je nach geforderter mechanischer Stabilität der Lotträgerschicht zumindest eines der genannten Metalle zu Bildung der Metallpartikel verwendet werden und gleichzeitig beispielweise Materialkosten besonders gering gehalten werden.

In vorteilhafter Ausgestaltung der Erfindung wird beziehungsweise werden die Paste und/oder das Lot und/oder die Lotträgerschicht vor und/oder nach der Infiltration thermisch behandelt. Dadurch kann beispielsweise eine besonders gute Lagerbarkeit von insbesondere sogenannten Substratgroßkarten, welche mehrere Baueinheiten mit jeweiligen Substraten aufweisen, realisiert werden. Dies kann beispielweise ein Trocknen der Paste durch insbesondere erhöhen einer Umgebungstemperatur umfassen, welche im Anschluss an den Druck stattfindet. Das heißt die Paste wird während der thermischen Behandlung weniger viskos, beispielweise, weil zusätzlich Werkstoffe in der Paste enthalten sein können, welche den Druck der Paste auf das Substrat besonders einfach machen, aus der Paste entweichen können.

In vorteilhafter Ausgestaltung der Erfindung wird das Lot vor der Infiltration, insbesondere vorzugsweise nach dem zweiten Schritt, auf zumindest einen Bereich der Paste appliziert. Alternativ oder zusätzlich wird das Lot vor der Infiltration und vorzugsweise nach dem zweiten Schritt, auf zumindest eine sich an den Teilbereich anschließenden und von der Paste freien Teil des Substrats appliziert. Dabei befindet sich der freie Teil des Substrats zumindest teilweise in direkter Nachbarschaft mit dem Teilbereich, auf welchem die Paste auf dem Substrat aufgetragen ist. Das heißt, der von der Paste freie Teil ist ein Bereich des Substrats, auf welchem die Paste nicht aufgebracht ist. Mit anderen Worten erfolgt eine Applikation von Lot auf zumindest einen Teil der Paste und/oder auf zumindest einen Teil des Substrats, welcher zumindest teilweise in direkter Nachbarschaft mit dem Teilbereich ist. Durch die Applikation ist in besonders vorteilhafter Weise eine Infiltration der Paste mit dem Lot realisierbar.

In vorteilhafter Ausgestaltung der Erfindung wird als die Drucktechnik zum Aufbringen der Paste Schablonendruck und/oder Siebdruck verwendet. Mit anderen Worten wird die Paste mittels Schablonendruck und/oder Siebdruck auf zumindest einen Teilbereich des Substrats platziert. Sowohl der Schablonendruck als auch der Siebdruck haben für das Aufbringen der Paste den Vorteil, dass die Paste beziehungsweise ein Pastendepot auf dem Substrat besonders eben aufgebracht beziehungsweise angelegt werden kann. Die Ebenheit ist insbesondere bei dem sich an das Verfahren anschließenden Diffusionslöten für eine zweckmäßige und vorteilhafte Ausbildung beispielsweise eines Lotspalts vorteilhaft, um eine besonders hohe Güte der Lötverbindung zu erhalten. Für eine Nutzung der Restreaktivität beziehungsweise Reaktivität des verbleibenden Lotes, an einer Oberfläche beziehungsweise der Oberseite der infiltrierten Paste, welches zumindest aus dem Lot, den Lotpartikeln und dem Metallpartikeln gebildet ist, ist es zweckmäßig, dass bei einem späteren Löten, insbesondere Diffusionslöten, beim Inkontaktbringen des Bauteils der Lotspalt eine besonders geringe Höhe aufweist, sodass intermetallischen Phasen bis zum Bauteil innerhalb eines üblichen Lotprofils durchwachsen können.

In vorteilhafter Ausgestaltung der Erfindung erfolgt das Anpassen der Oberflächentopographie mittels eines antiadhäsiven Stempels. Dabei kann der Stempel beziehungsweise insbesondre dessen Prägefläche aus Teflon gebildet sein, welches besonders haftungsarm mit der zu anzupassenden Oberfläche der aufgebrachten Paste reagiert. Dadurch ist in besonders vorteilhafter und effizienter Weise beispielweise eine Glättung der Oberfläche möglich.

In vorteilhafter Ausgestaltung der Erfindung ist das Substrat zumindest ein Teil eines Verdrahtungsträgers. Der Verdrahtungsträger kann als mechanischer Träger, insbesondere für die Verdrahtung von Leitungsstrukturen mit dem, insbesondere elektronischen, Bauteil dienen. Bei dem Verdrahtungsträger kann in besonders effizienter Weise ein an das Verfahren anschließendes Diffusionslöten, insbesondere mittels der bestehenden Fertigungslinie, erfolgen.

In vorteilhafter Ausgestaltung der Erfindung wird zumindest auf eine dem Substrat abgewandten Oberfläche der Lotträgerschicht eine Verzinnung aufgebracht. Dabei kann die Oberfläche insbesondere die oben genannte Oberfläche sein beziehungsweise mit dieser zusammenfallen, durch welche die organischen Elemente entweichen können. Zusätzlich ist die Oberfläche zumindest teilweise eine Fläche der Lotträgerschicht, welche bei dem auf das Verfahren folgenden Diffusionslöten mit dem Bauteil verbunden werden kann. Die Verzinnung kann insbesondere sogenanntes "chemisch Zinn" umfassen beziehungsweise aufweisen, welches im Allgemeinen besonders vorteilhaft eine plane, lotfähige, metallische Oberfläche ausbilden kann. Durch das Aufbringen der Verzinnung auf die Lotträgerschicht kann in einfacher und vorteilhafter Weise beispielsweise eine Steigerung der in der Lotträgerschicht verfügbaren Menge an Lot für das anschließende Fügen der Baueinheit mit dem Bauteil, welche auch jeweils als Fügepartner bezeichnet werden können, bereitgestellt werden. Alternativ oder zusätzlich kann die Verzinnung, das heißt das Aufbringen des, insbesondere chemisch, Zinns auf dem von der Baueinheit unterschiedlichen Fügepartner, insbesondere dem Bauteil, erfolgen. Das heißt, das Zinn wird nicht auf der Lotträgerschicht der Baueinheit aufgebracht, sondern auf dem Bauteil. Insbesondere dient das Aufbringen der Verzinnung zur Schaffung einer dünnen, lötbaren Schicht, insbesondere auf dem Lotträger. Dafür kann alternativ zu der, insbesondere chemischen, Verzinnung eine galvanische Abscheidung durchgeführt werden. Insbesondere kann beziehungsweise können die Verzinnung und/oder die galvanische Abscheidung vorteilhaft sein, wenn die Lotträgerschicht, beispielsweise besonders lange und/oder intensiv durch thermische Behandlung getrocknet wurde und/oder in einem zusätzlichen Verfahrensschritt oder vor dem Verfahren oder nach dem dritten Schritt des Verfahren thermisch behandelt wurde.

In vorteilhafter Ausgestaltung der Erfindung wird die Lotträgerschicht zumindest einer, insbesondere thermischen, Behandlung unterzogen, wodurch eine Ausbreitung wenigstens einer intermetallischen Phase in der Lotträgerschicht gefördert wird. Die Behandlung kann, beispielsweise insbesondere im dritten Schritt des Verfahrens und/oder in Anschluss an diesen erfolgen beziehungsweise durchgeführt werden, um eine Ausbildung beziehungsweise ein Wachstum von intermetallischen Phasen in dem Gemisch aus Lotpartikeln und Metallpartikeln in der Paste zu forcieren. Findet eine besonders weitreichende Umwandlung in beziehungsweise Bildung der intermetallischen Phasen statt, kann sich ein Vorteil ergeben. Dieser ist ein besonders geringes Volumensschrumpfen innerhalb einer Fügezone zwischen den Fügepartner, insbesondere bei einem späteren Betrieb der Baugruppe, das heißt des zusammengelöteten Bauteils mit der Baueinheit. Jedoch kann sich durch eine frühzeitige Lotumwandlung beziehungsweise Ausbildung der intermetallischen Phasen ein Verlust einer Ausgleichswirkung der Lotträgerschicht während des Fügeprozesses ergeben.

In vorteilhafter Ausgestaltung der Erfindung weist zumindest ein Teil der Metallpartikel der Paste jeweils zumindest eine funktionale Beschichtung auf. Die Beschichtung und die Metallpartikel, welche jeweils insbesondere als kleine Kupferkugel ausgebildet sein können, sind aus zumindest teilweise voneinander unterschiedlichen Werkstoffen gebildet. Ferner ist die Beschichtung nicht das Lot und nicht die Lotpartikel. Diese sind ebenfalls jeweils aus zumindest einem Werkstoff gebildet, welcher sowohl jeweils unterschiedlich für das Lot im Vergleich zu den Lotpartikeln sein kann. Die funktionale Beschichtung kann zumindest eine Funktion übernehmen und ist insbesondere auf jeweils einen der Metallpartikel aufgebracht. So kann die Beschichtung die Ausbildung der intermetallischen Phase an den Metallpartikeln verzögern. Dabei kann die Verzögerung insbesondere während der Schritte 1 bis 3, insbesondere während des zweiten Schritts des Verfahrens, stattfinden. Es können mehrere funktionale Schichten vorgesehen sein, sodass ein jeweiliges Metallpartikel mehrere aufeinander folgende und insbesondre voneinander unterschiedliche Beschichtungen aufweisen kann. So können die Beschichtungen beispielsweise eine Abfolge aufweisen, bei welcher auf eine benetzungsfördernde Schicht beziehungsweise Beschichtung eine benetzungshemmende Schicht folgt. Alternativ oder zusätzlich kann auf eine benetzungshemmende eine benetzungsfördernde Schicht folgen und umgekehrt beziehungsweise ist eine beliebige Abfolge der jeweils eine Schicht bildenden Beschichtung, insbesondere einer funktionalen Beschichtung, möglich. Dabei hat benetzungshemmende Beschichtung die Eigenschaft, dass sich der jeweilige Metallpartikel aufgrund der Beschichtung nicht besonders gut beispielsweise mit dem Lot benetzen lässt, bei der benetzungsfördernde Beschichtung kann das Gegenteil der Fall sein. Der Vorteil der funktionalen Beschichtung ist beispielsweise eine Aufrechterhaltung einer Beweglichkeit der Metallpartikel und/oder einer Restfraktion an schmelzflüssigen Bereichen in der Fügezone beim Diffusionslöten, um beispielsweise die Ausgleichwirkung während des Fügeprozesses zu gewährleisten beziehungsweise ein gewisses Mindestmaß an Ausgleichswirkung bereitstellen zu können. So kann durch eine benetzungshemmende Beschichtung, welche insbesondere metallurgisch inaktiv ist, eine leichte Umordnung der Metallpartikel beziehungsweise eine hohe Beweglichkeit der Metallpartikel in dem sie umgebenden Lot beziehungsweise den Lotpartikeln stattfinden, sodass sich beispielsweise die Gitterstruktur besonders vorteilhaft ausbildet.

In vorteilhafter Ausgestaltung der Erfindung erfolgt ein Verbinden des Bauteils mit einem Substrat mittels Diffusionslöten. Das Verfahren umfasst dabei folgende Schritte: In einem ersten Schritt wird eine Baueinheit bereitgestellt, welche das Substrat und eine unabhängig von dem Bauteil an dem Substrat gehaltene, feste Lotträgerschicht aufweist, die eine mit Lot infiltrierte Paste aufweist. Mit anderen Worten weist die Baueinheit in einem von dem Bauteil getrennten Zustand, das heißt ohne dass das Substrat mit dem Bauteil verbunden ist, die Lotträgerschicht auf. In einem zweiten Schritt des Verfahrens wird zumindest ein zu verlötender Bereich des Bauteils in Kontakt mit der Lotträgerschicht gebracht. In einem dritten Schritt des Verfahrens erfolgt das Verlöten des Substrats mit dem Bauteil über die Lotträgerschicht mittels Diffusionslöten, bei dem die Lotträgerschicht zumindest teilweise aufgeschmolzen wird. Dabei wird der Lötvorgang des Diffusionslötens insbesondere durch beziehungsweise über eine Aktivierung in Gang gesetzt. Die Aktivierung kann dabei auf unterschiedliche Arten erfolgen. Beispielsweise kann die Aktivierung durch ein Gas und/oder durch die Zugabe eines Flussmittels, einem sogenannten additiven Flux, erfolgen. Bei der Aktivierung durch das Gas werden die Baueinheit und das Bauteil in eine reduzierende Atmosphäre, welche beispielsweise Ameisensäure aufweisen kann, eingebracht. Dadurch können an metallenen Oberflächen, insbesondere der Lotträgerschicht und/oder des Bauteils, metallene Verbindungen, welche sich dort, insbesondere durch Oxidationen, gebildet haben können, zurück zu einem reinen Metall reduziert werden, sodass das Verlöten in besonders vorteilhafter Weise starten kann und die fertige Lötverbindung eine besonders hohe Qualität aufweist. Der Lötvorgang selbst erfolgt vorteilhafterweise in der Standard-Fertigungslinie. Beim Verlöten erfolgt nach einem Auf- beziehungsweise zumindest Anschmelzen des Lots, insbesondere durch Diffusionsprozesse, aber auch durch Kapillarprozesse, eine Bildung einer Kontaktschicht, welche durch die zufällige Verteilung der Metallpartikel in der Lotträgerschicht insbesondere besonders temperaturstabil ist. Diese entsteht insbesondere durch eine auf das Aufschmelzen folgende Verfestigung des Lots.

Erfindungsgemäß ist die Baueinheit mittels eines Verfahrens nach einem der Ansprüche 1 bis 9 hergestellt.

In vorteilhafter Ausgestaltung der Erfindung ist das Bauteil ein oberflächenmontiertes Bauteil. Ein oberflächenmontierten Bauteil wird im Englischen als Surface Mount Device (SMD) bezeichnet. Diese Bauteile haben im Gegensatz zu Bauteilen einer sogenannten Durchsteckmontage beispielsweise den Vorteil, dass eine sie tragende Leiterplatte, welche beispielsweise die Baueinheit ist, platzsparender gelötet werden kann.

Vorteilhafte Ausgestaltungen des ersten Aspekts der Erfindung sind als vorteilhafte Ausgestaltungen des zweiten Aspekts der Erfindung anzusehen und umgekehrt.

Ausführungsbeispiele der Erfindung werden nachfolgend anhand schematischer Zeichnungen näher erläutert. Es zeigt:
FIG 1 Ablauf des erfindungsgemäßen Verfahrens zum Herstellen einer Baueinheit anhand schematischer Darstellungen von Verfahrensschritten;
FIG 2 schematische Darstellung eines Anpassen der Oberflächentopographie einer Paste, als weiterer Schritt des Verfahrens;
FIG 3 schematische Darstellung einer Verzinnung einer Lotträgerschicht;
FIG 4 Ablauf des erfindungsgemäßen Verfahrens zum Verbinden eines Bauteils mit einem Substrat mittels Diffusionslöten anhand schematischer Darstellungen von Verfahrensschritten;
FIG 5 schematische Darstellung eines Metallpartikels der Paste, welcher eine Beschichtung aufweist; und
FIG 6 schematische Draufsicht einer als wenigsten ein Verdrahtungsträger ausgebildeten Substratgroßkarte.

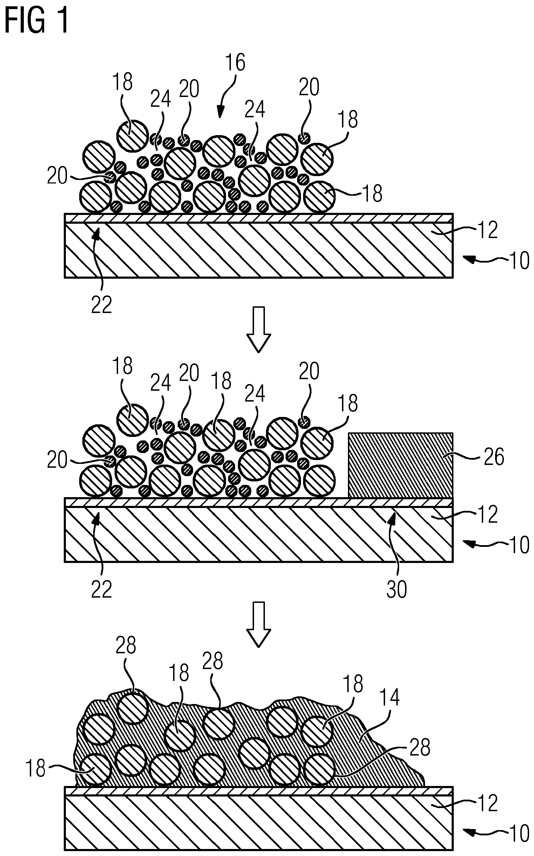

Ein Ziel des Verfahrens ist eine Vorkonfektionierung einer Baueinheit 10 für ein möglicherweise später folgendes, insbesondere effizientes, Diffusionslöten, insbesondere in üblichen Fertigungslinien mit bestehendem Fertigungsequipment. Durch das Verfahren kann in besonders vorteilhafter Weise die Herstellung einer zuverlässigen, hochtemperaturstabilen beziehungsweise hochschmelzenden Diffusionslötverbindung ermöglicht werden. Beziehungsweise dient das Verfahren zum effizienten Erzeugen eines zum Diffusionslöten vorbereiteten Substrats 12 beziehungsweise einer Baueinheit 10. Dabei umfasst das Verfahren zum effizienten Erzeugen des zum Diffusionslöten vorbereiteten Substrats 12 beziehungsweise der Baueinheit 10 mehrere Schritte:
In einem ersten Schritt i. wird das Substrat 12 der Baueinheit 10 bereitgestellt. Dabei ist das Substrat 12 zumindest ein Teilbereich der Baueinheit 10, welcher insbesondere behandelbar ist, sodass auf zumindest den Teilbereich des Substrats 12 durch das Verfahren eine Lotträgerschicht 14 ausgebildet werden kann. In der FIG 1 sind einzelnen, aufeinander folgenden Schritten teilweise durch einen Pfeil abgegrenzt, wobei die Richtung des Pfeils die zeitliche Reihenfolge der Schritte des Verfahrens, der sogenannten Verfahrensschritte, angibt. Dabei ist in der ersten schematischen Darstellung, welche die oberste Darstellung der FIG 1 ist, bereits das Ergebnis eines zweiten Schritts ii. des Verfahrens gezeigt. Das heißt, der erste Verfahrensschritt i., das Bereitstellen des Substrats 12, hat ebenfalls bereits in der obersten Darstellung der FIG 1 stattgefunden.

In einem zweiten Schritt ii. wird eine Paste 16, welche zumindest Metallpartikel 18 und von den Metallpartikeln 18 unterschiedliche Lotpartikel 20 aufweist, auf zumindest einem Teilbereich 22 des Substrats 12 mittels einer Drucktechnik aufgebracht. Dabei unterscheiden sich die Metallpartikel 18 von den Lotpartikeln 20 insbesondere dadurch, dass die unterschiedlichen Partikelarten jeweils aus unterschiedlichen Werkstoffen gebildet sind. Die Metallpartikel 18 können beispielweise aus Kupfer und/oder Eisen und/oder Nickel und/oder Silber und/oder Gold gebildet sein. Ferner weist die auf den Teilbereich 22 im zweiten Schritt ii. aufgebrachte Paste 16 Hohlräume 24 auf.

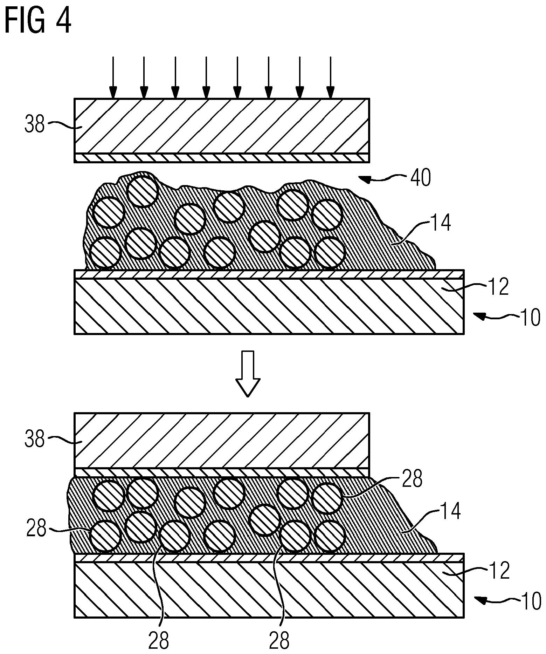

In einem dritten Schritt iii. des Verfahrens, dessen Anfang in der mittleren Darstellung der FIG 1 und dessen Resultat in der untersten Darstellung der FIG 1 gezeigt ist, wird die Paste 16 mit Lot 26 unter Abwesenheit des Bauteils infiltriert, wodurch die mit dem Lot 26 infiltrierte Paste 16 die Lotträgerschicht 14 bildet. Unter Abwesenheit des Bauteils, welches in FIG 4 gezeigt wird, bedeutet, dass eine Verbindung zwischen Bauteil und Baueinheit 10, insbesondere mittels der Lotträgerschicht 14, unterbleibt. Das heißt, in dem vorgestellten Verfahren wird das Bauteil nicht mit der Baueinheit 10, insbesondere mittels Diffusionslöten, verlötet. Das Verfahren dient dazu, in besonders vorteilhafter Weise die Lotträgerschicht 14 auszubilden beziehungsweise bereitzustellen, sodass beispielsweise ein Verlöten, welches später in dem zweiten Verfahren vorgestellt wird, in der bestehenden Fertigung insbesondere in der bestehenden Fertigungsanlage möglich ist. Das Einbringen beziehungsweise Infiltrieren des Lots 26 in die Paste 16 erfolgt dabei analog des Diffusionslötens. Das heißt, das Lot 26 zieht besonders gut, insbesondere aufgrund von Diffusions- und möglicherweise darüber hinaus stattfindenden Kapillarprozessen in die Paste 16 ein. Dies kann beispielsweise durch Hinzuführen beziehungsweise Einstrahlen von Wärme auf das Substrat 12 und/oder die Paste 16 erfolgen. Bei der Infiltration bilden sich insbesondere durch die Metallpartikel 18 und die Lotpartikel 20, aber ebenso möglicherweise durch einen Teil des Lots 26, intermetallische Phasen 28 aus, deren Wachstum insbesondere an einer jeweiligen Oberfläche eines jeweiligen Metallpartikels 18 beginnen kann. Der Werkstoff der Lotpartikel 20 kann von dem Werkstoff des Lots 26 unterschiedlich sein. So kann beispielsweise einer der Werkstoffe zusätzlich ein Flussmittel enthalten beziehungsweise eine erste Art eines Flussmittels, wohingegen der andere Werkstoff eine andere Art eines Flussmittels oder ähnliches enthält.

Ferner zieht beim Ausbilden der Lotträgerschicht 14 das Lot 26 insbesondere in die Hohlräume 24, welche die Paste 16 bis wenigstens zum dritten Verfahrensschritt iii. aufweist, ein. Die unterste Darstellung in FIG 1 zeigt die fertige Lotträgerschicht 14 auf dem Substrat 12 der Baueinheit 10. Dabei ist das Substrat 12 nun in besonders vorteilhafter Weise für ein später stattfindendes Diffusionslöten vorbereitet. Das hier geschaffene Substrat 12 beziehungsweise das mit der Lotträgerschicht 14 ausgebildete Bauteil gleicht einem sogenannten Halbzeug und kann beispielsweise besonders vorteilhaft in der bestehenden Fertigungslinie beziehungsweise einer bestehenden Produktionsanlage insbesondere für Elektronik und insbesondere ohne Änderung für ein späteres Diffusionslöten benutzt werden. Dadurch können beispielsweise aufwendige Umbauten und somit Kosten eingespart werden.

Die Paste 16 und/oder das Lot 26 und/oder die Lotträgerschicht 14 können vorteilhafterweise vor und/oder nach der Infiltration thermisch behandelt werden. Durch die thermische Behandlung kann beispielweise eine Trocknung bewirkt werden. Durch die Trocknung wird die Paste 16 beispielsweise formstabiler, sodass eine darauffolgende Weiterbehandlung, insbesondere durch einen dritten Verfahrensschritt iii, besonders vorteilhaft an dem wenigstens einen dafür vorgesehenen Teilbereich 22 erfolgen kann.

Vorteilhafterweise kann das Lot 26 beziehungsweise die Lotträgerschicht 14 nach der im dritten Schritt iii. erfolgten Infiltration getrocknet werden. Dadurch ist beispielsweise für eine sich an das Verfahren anschließende Weiterverarbeitung eine besonders einfache Handhabbarkeit der jeweiligen Baueinheit 10 realisierbar.

Wie in der mittleren Darstellung der FIG 1 kann vorteilhafterweise, insbesondere nach dem zweiten Schritt ii. beziehungsweise insbesondere vor der Infiltration im dritten Schritt iii. des Verfahrens, auf zumindest einen sich an den Teilbereich 22 anschließenden und von der Paste 16 freien Teil 30 des Substrats 12 appliziert werden. Zusätzlich oder alternativ kann das Lot 26 vor der Infiltration und vorzugsweise nach dem zweiten Schritt ii, beziehungsweise insbesondere nach dem dritten Schritt iii, auf zumindest einen Bereich der Paste 16 appliziert werden. Bei der Applikation sowohl auf den freien Teil 30 als auch auf die Paste 16 kann das Lot 26 als eine, insbesondere flüssige beziehungsweise viskose, Paste und/oder als wenigstens ein eigensteifes beziehungsweise insbesondere formstabiles Formteil aufgebracht werden.

Durch die Infiltration der Paste 16 unter Abwesenheit des Bauteils 10 läuft die Infiltration und somit das Erzeugen der Lotträgerschicht 14 wesentlich sicherer ab. Zudem wird ein Fehlstellengehalt zwischen den Metallpartikeln 18 deutlich reduziert, das heißt es bilden sich weniger sogenannte Lunker beziehungsweise Voids. Ferner können Gitterfehler beziehungsweise Fehlstellen eines sich zumindest teilweise aus eine Neuordnung der Metallpartikel 18 zueinander ausbildenden Gitters ebenfalls durch das Verfahren reduziert werden. Ferner können organische Bestandteile beispielsweise der Lotpartikel 20 und/oder des Lotes 26 besonders vorteilhaft, insbesondere als Gas aus der sich aus der Paste 16 und dem Lot 26 bildenden Lotträgerschicht 14 entweichen. Bei einem anschließenden Fügen durch Diffusionslöten der Baueinheit 10 mit beispielsweise dem Bauteil verbleibt somit weniger organischer Anteil innerhalb einer Fügezone, welche insbesondere durch die Lotträgerschicht 14 gebildet wird. Dadurch ist mittels der Lotträgerschicht 14 eine besonders vorteilhafte Lötverbindung herstellbar. Darüber hinaus bilden sich im Gegensatz zu einem konventionellen Diffusionslöten weniger, insbesondere geschlossene, Kammern beim insbesondere isothermen Erstarren der intermetallischen Phasen, bei welchen Metallpartikel 18 miteinander verbunden werden.

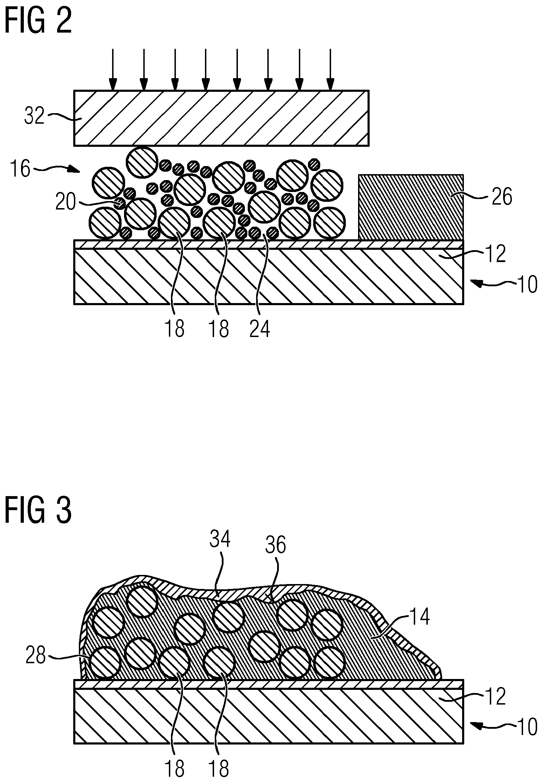

FIG 2 zeigt eine schematische Darstellung eines Anpassens der Oberflächentopographie der Paste 16 als weiteren, insbesondere optionalen, Schritt des Verfahrens. Im gezeigten Ausführungsbeispiel ist das Anpassen der Oberflächentopographie ein Planarisieren. Vorteilhafterweise erfolgt das Planarisieren der Paste 16 auf dem Substrat 12 vor dem dritten Schritt iii. und nach dem zweiten Schritt ii. Durch das Planarisieren, welches zumindest teilweise bereits durch den Druck erfolgt, kann eine vorteilhafte Ebenheit der Lotträgerschicht 14 realisiert werden. Besonders einfach kann dies mittels eines, insbesondere antiadhäsiven, Stempels 32 erfolgen, welcher auf die Paste 16, insbesondere planparallel zu dem Substrat 12, gedrückt wird. Dabei kann eine Prägefläche des Stempels 32 aus Teflon gebildet sein. Mittels des Planarisierens beziehungsweise Anpassen der Oberflächentopographie kann in einem späteren Lötverfahren, wie beispielsweise das in FIG 4 vorgestellte, ein Lotspalt eine besonders geringe Höhe aufweisen, sodass beispielsweise die intermetallischen Phasen bis zu dem Bauteil durchwachsen können.

FIG 3 zeigt eine schematische Darstellung einer Verzinnung 34. In vorteilhafter Ausgestaltung der Erfindung erfolgt in einem insbesondere weiteren, optionalen Schritt des Verfahrens das Aufbringen der Verzinnung 34 zumindest auf einer dem Substrat 12 abgewandten Oberfläche 36 der Lotträgerschicht 14. Generell wird bei dem vorgestellten Verfahren das verbleibende Lot 26, beziehungsweise zumindest ein Teil des Lots 26, welcher insbesondere die Oberfläche 36 der Lotträgerschicht 14 formt, für eine spätere Bauteilkontaktierung ausgenutzt. Durch die Verzinnung 34, welche insbesondere aus sogenanntem "chemisch Zinn" ausgebildet sein kann, kann die verfügbare Lotmenge gesteigert werden, sodass die Bauteilkontaktierung besonders vorteilhaft erfolgen kann. Ferner kann die Reaktivität, insbesondere eine verbleibende Restreaktivität beziehungsweise Oberflächenreaktivität vorteilhafterweise beeinflusst werden. Somit kann beispielweise ein Lotprozess bei einem späteren Diffusionslöten besonders einfach eingeleitet werden.

Ferner kann die Baueinheit 10 und die auf sie aufgebrachte Lotträgerschicht 14 alternativ oder zusätzlich zum Aufbringen der Verzinnung 34 einer, insbesondere thermischen, Behandlung unterzogen werden. Bei dieser Behandlung kann eine Ausbreitung wenigstens einer intermetallischen Phase 28 in der Lotträgerschicht 14 gefördert werden. Alternativ kann anstelle der Verzinnung 34 beispielsweise eine galvanische Abscheidung an der Oberfläche 36 durchgeführt werden. Sowohl die Verzinnung 34 als auch die galvanische Abscheidung dienen als Maßnahme zur Schaffung einer, insbesondere dünnen, lötbaren Schicht insbesondere auf der Oberfläche 36. Beispielsweise kann mittels einer, insbesondere besonders langen und/oder heißen, thermische Vorbehandlung eine große Ausbildung intermetallische Phasen 28 erreicht werden.

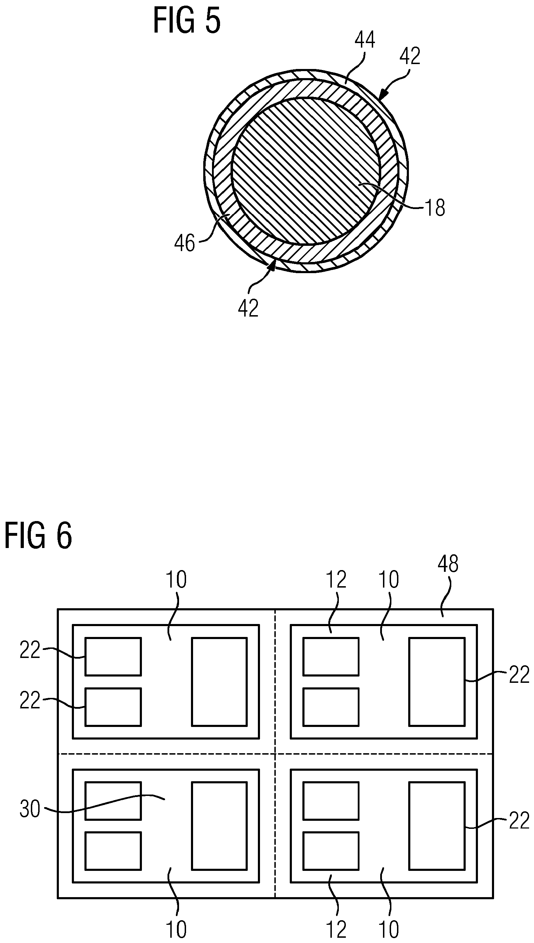

Jedoch kann die, insbesondere thermische, Behandlung mit einem weitgehenden Verlust einer Ausgleichswirkung der Schicht im Fügeprozess einhergehen, da beispielsweise eine Mobilität der Metallpartikel 18 heruntergesetzt wird. Die Verzinnung 34 kann diesen Effekt etwas kompensieren. Ferner kann dem Effekt mit beschichteten Metallpartikeln 18, wie einer exemplarisch in FIG 5 gezeigt ist, zumindest teilweise entgegengewirkt werden. Details hierzu in der Beschreibung zu FIG 5.

Anderseits kann sich eine große Ausbildung intermetallische Phasen 28 bereits vor dem eigentlichen Diffusionslöten besonders vorteilhaft auf den anschließenden Lötprozess auswirken. Durch die Behandlung und das damit einhergehende verstärkte Umwandeln in intermetallische Phasen 28, insbesondere bereits vor oder während der Schaffung der Lotträgerschicht 14, bietet den Vorteil, dass insbesondere während eines späteren Betriebs einer Baugruppe, welche aus der Baueinheit 10 und dem später gezeigten Bauteil gebildet ist, innerhalb der Fügezone ein besonders geringes Volumenschrumpfen auftreten kann beziehungsweise auftritt.

FIG 4 zeigt einen Ablauf eines zweiten Verfahrens. Dieses zweite Verfahren dient zum Verbinden eines Bauteils 38 mit dem Substrat 12, insbesondere der Baueinheit 10, mittels Diffusionslötens. Das in FIG 4 vorgestellte Verfahren wir im weiteren Text häufig als zweites Verfahren bezeichnet, insbesondere dann, wenn eine Unterscheidung zu dem in FIG 1 vorgestellten ersten Verfahren verdeutlicht werden soll. Dabei umfasst das zweite Verfahren mehrere Schritte. In einem ersten Schritt i. des Verfahrens zum Verbinden des Bauteils 38 wird die Baueinheit 10 bereitgestellt. Dabei weist die Baueinheit 10 das Substrat 12 und eine unabhängig von dem Bauteil 38 an dem Substrat 12 gehaltene, feste Lotträgerschicht 14 auf. Die Lotträgerschicht 14 weist dabei eine mit Lot 26 infiltrierte Paste 16 auf, beziehungsweise kann die Lotträgerschicht 14 zumindest teilweise aus dieser Paste 16 gebildet sein. Das heißt, das Substrat 12 weist die Lötträgerschicht 14 bereits in einem von dem Bauteil 38 getrennten Zustand auf. Mit anderen Worten ist die Lotträgerschicht 14 bereits an das Substrat 12 gebundenen bereits bevor die Lotträgerschicht 14 während des zweiten Verfahrens mit dem Bauteil 38 verbunden wird.

In besonders vorteilhafter Ausgestaltung wird als die Baueinheit 10 mittels des ersten, in FIG 1 vorgestellten Verfahrens beziehungsweise nach einem Verfahren mit den zusätzlichen Schritten, wie in FIG 2 und FIG 3 dargestellt, hergestellt.

In einem zweiten Schritt ii. des zweiten Verfahrens erfolgt ein Inkontaktbringen zumindest eines zu verlötenden Bereichs 40 des Bauteils 38 mit der Lotträgerschicht 14. Dies zeigt die obere Darstellung der FIG 4, bei welcher das Bauteil 38, insbesondere mit einer Oberfläche des Bereichs 40 in Kontakt gebracht wird beziehungsweise steht. In einem dritten und letzten Schritt des Verfahrens wird das Substrat 12 mit dem Bauteil 38 über die Lotträgerschicht 14 mittels Diffusionslöten, bei dem die Lotträgerschicht 14 zumindest teilweise aufgeschmolzen wird, verlötet. Dieser fertige verlötete Zustand ist in der unteren Darstellung der FIG 4 gezeigt. Durch den Lötprozess des Diffusionslötens können sich die intermetallischen Phasen, wie in der FIG 4 zu sehen, weiter ausbilden, wodurch beispielsweise insbesondere eine besonders hohe Wärmeleitfähigkeit der Lötverbindung ausgebildet werden kann.

Vorteilhafterweise ist das Bauteil 38 ein oberflächenmontiertes Bauteil, wie es beispielsweise bei einer Oberflächenmontage im Gegensatz zu einer Durchsteckmontage verwendet wird, wodurch sich beispielsweise besonders flache Baugruppen aus Bauteil 38 und Baueinheit 10 ausbilden lassen.

FIG 5 zeigt eine schematische Darstellung eines Metallpartikels 18 der Paste 16, welche eine Beschichtung aufweist. Vorteilhafterweise können für das erste und auch das zweite Verfahren, jedoch insbesondere während des ersten Verfahrens, Metallpartikel 18 verwendet werden, welche zumindest einen Teil der Metallpartikel 18 der Paste 16 darstellen, welche jeweils zumindest eine funktionale Beschichtung 42 aufweisen. Dabei kann beispielsweise die außenliegende Schicht 44 eine Beschichtung 42 sein, welche die Ausbildung der intermetallischen Phasen 28 an den Metallpartikeln 18 hemmt beziehungsweise verzögert. Dadurch kann beispielsweise eine Beweglichkeit der Metallpartikel 18 in dem aufschmelzenden Lot der Lotpartikel 20 beziehungsweise dem Lot 26 aufrecht erhalten werden, wodurch beispielsweise eine besonders vorteilhafte zumindest teilweise Gitteranordnung der Metallpartikel 18 erfolgen kann. Durch eine weitere Schicht oder die Schicht 44 kann die Beweglichkeit beispielsweise auch im Fügeprozess aufrechterhalten werden. Eine zweite Schicht 46 kann im Gegensatz zu der benetzungshemmenden Schicht 44 als benetzungsfördernde Schicht ausgebildet sein. Eine quasi beliebige Abfolge von benetzungshemmenden und benetzungsfördernden Schichten 44 und 46 ist denkbar. Dabei kann auch eine metallurlogisch inaktive Schicht verwendet werden, insbesondere als zweite Schicht 46 beziehungsweise zweite Beschichtung, welche beispielsweise eine leichte Bewegbarkeit der Metallpartikel 18 im Lot 26 erlaubt. Dagegen kann die besser benetzbare beziehungsweise benetzende Schicht die Umverteilung erleichtern. So kann beispielsweise durch die funktionale Beschichtung 42 die Ausgleichswirkung während des Fügeprozesses, welcher durch das in FIG 4 gezeigte Verfahren charakterisiert ist, gewährleistet werden. Dabei sind die Beschichtung und die Metallpartikel 18 jeweils aus voneinander unterschiedlichen Werkstoffen ausgebildet, das heißt die Beschichtung ist nicht das Lot 26 und auch nicht die Lotpartikel 20, sondern ein von diesen Materialien unterschiedlicher Werkstoff.

FIG 6 zeigt eine schematische Draufsicht einer als wenigstens ein Verdrahtungsträger ausgebildeten Substratgroßkarte 48. An der Substratgroßkarte 48 ist besonders gut die jeweilige Baueinheit 10 mit jeweiligen Teilbereichen 22 zu erkennen. Besonders vorteilhaft kann der jeweilige Teilbereich 22 der Baueinheit 10 insbesondere in seiner Form durch das Verwenden einer Drucktechnik in dem zweiten Verfahrensschritt ii. des ersten Verfahrens erzeugt werden. Als geeignete Drucktechniken bieten sich besonders der Schablonendruck und/oder der Siebdruck an, mittels welchen der Teilbereich 22, welcher sich insbesondere von dem lotfreien beziehungsweise pastefreien Teil 30 des Substrats 12 abgrenzt. Vorteilhafterweise ist das Substrat 12 beziehungsweise die das Substrat 12 aufweisende Baueinheit 10 der bereits eingangs erwähnte Verdrahtungsträger, welcher bei einer Verdrahtung beziehungsweise dem durch Löten zu verbindenden Bauteil 38 als Träger dienen kann.

## Patentansprüche

1. Verfahren zum Herstellen einer mit wenigstens einem Bauteil durch Diffusionslöten zu verlötenden und unabhängig von dem Bauteil (38) ausgebildeten Baueinheit (10), mit den Schritten:
i. Bereitstellen eines Substrats (12) der Baueinheit (10);
ii. Aufbringen einer Paste (16), welche zumindest Metallpartikel (18) und von den Metallpartikeln (18) unterschiedliche Lotpartikel (20) aufweist, auf zumindest einen Teilbereich (22) des Substrats (12) mittels einer Drucktechnik;
iii. Infiltration der Paste (16) mit Lot (26) unter Abwesenheit des Bauteils (38), wodurch die mit dem Lot (26) infiltrierte Paste (16) eine Lotträgerschicht (14) bildet,
**dadurch gekennzeichnet, dass**
- das Lot (26) als wenigstens ein eigensteifes Formteil appliziert wird; und/oder
- ein Anpassen der Oberflächentopographie der Paste (16) mittels eines Stempels (32) auf dem Substrat (12) erfolgt.

2. Verfahren nach Anspruch 1, **dadurch gekennzeichnet, dass** die Metallpartikel aus Kupfer und/oder Eisen und/oder Nickel und/oder Silber und/oder Gold gebildet sind.

3. Verfahren nach Anspruch 1 oder 2, **dadurch gekennzeichnet, dass** die Paste (16) und/oder das Lot (26) und/oder die Lotträgerschicht (14) vor und/oder nach der Infiltration thermisch behandelt werden.

4. Verfahren nach einem der vorhergehenden Ansprüche, **dadurch gekennzeichnet, dass** das Lot (26) vor der Infiltration auf zumindest einen Bereich der Paste (16) und/oder auf zumindest einen sich an den Teilbereich (22) anschließenden und von der Paste (16) freien Teil (30) des Substrats (12) appliziert wird.

5. Verfahren nach einem der vorhergehenden Ansprüche, **dadurch gekennzeichnet, dass** als die Drucktechnik Schablonendruck und/oder Siebdruck verwendet wird.

6. Verfahren nach einem der vorhergehenden Ansprüche, **dadurch gekennzeichnet, dass** das Substrat (12) zumindest ein Teil eines Verdrahtungsträgers ist.

7. Verfahren nach einem der vorhergehenden Ansprüche, **dadurch gekennzeichnet, dass** zumindest auf eine dem Substrat (12) abgewandte Oberfläche (36) der Lotträgerschicht (14) eine Verzinnung (34) aufgebracht wird.

8. Verfahren nach einem der vorhergehenden Ansprüche, **dadurch gekennzeichnet, dass** die Lotträgerschicht (14) zumindest einer, insbesondere thermischen, Behandlung unterzogen wird, wodurch eine Ausbreitung wenigstens einer intermetallischen Phase (28) in der Lotträgerschicht (14) gefördert wird.

9. Verfahren nach einem der vorhergehenden Ansprüche, **dadurch gekennzeichnet, dass** zumindest ein Teil der Metallpartikel (18) der Paste (16) jeweils zumindest eine funktionale Beschichtung (42, 44, 46) aufweisen.

10. Verfahren zum Verbinden eines Bauteils (38) mit einem Substrat (12) mittels Diffusionslöten, mit den Schritten:
i. Herstellen und Bereitstellen einer Baueinheit (10), welche das Substrat (12) und eine unabhängig von dem Bauteil (38) an dem Substrat (12) gehaltene, feste Lötträgerschicht (14) aufweist, die eine mit Lot (26) infiltrierte Paste (16) aufweist;
ii. Bringen zumindest eines zu verlötenden Bereiches (40) des Bauteils (38) in Kontakt mit der Lotträgerschicht (14) ;
iii. Verlöten des Substrats (12) mit dem Bauteil (38) über die Lotträgerschicht (14) mittels Diffusionslöten, bei dem die Lotträgerschicht (14) zumindest teilweise aufgeschmolzen wird,
**dadurch gekennzeichnet, dass** die Baueinheit (10) mittels eines Verfahrens nach einem der Ansprüche 1 bis 9 hergestellt wird.

11. Verfahren nach Anspruch 10, **dadurch gekennzeichnet, dass** das Bauteil (10) ein oberflächenmontiertes Bauteil ist.

## Claims

1. Method for producing a structural unit (10) which is to be soldered to at least one component by diffusion soldering and is formed independently of the component (38), comprising the steps:
i. providing a substrate (12) of the structural unit (10);
ii. applying a paste (16), which comprises at least metal particles (18) and solder particles (20) different to the metal particles (18), onto at least one subregion (22) of the substrate (12) by means of a printing technique;
iii. infiltrating the paste (16) with solder (26) in the absence of the component (38), so that the paste (16) infiltrated with the solder (26) forms a solder carrier layer (14),
**characterized in that**
- the solder (26) is applied as at least one inherently rigid shaped part; and/or
- adaptation of the surface topography of the paste (16) is carried out by means of a stamp (32) on the substrate (12) .

2. Method according to Claim 1, **characterized in that** the metal particles are formed from copper and/or iron and/or nickel and/or silver and/or gold.

3. Method according to Claim 1 or 2, **characterized in that** the paste (16) and/or the solder (26) and/or the solder carrier layer (14) are heat-treated before and/or after the infiltration.

4. Method according to one of the preceding claims, **characterized in that** the solder (26) is applied before the infiltration onto at least one region of the paste (16) and/or onto at least one free part (30), which follows on from the subregion (22) and is free of the paste (16), of the substrate (12) .

5. Method according to one of the preceding claims, **characterized in that** stencil printing and/or screen printing is used as the printing technique.

6. Method according to one of the preceding claims, **characterized in that** the substrate (12) is at least a part of a circuit board.

7. Method according to one of the preceding claims, **characterized in that** tin plating (34) is applied at least onto a surface (36) of the solder carrier layer (14) that faces away from the substrate (12).

8. Method according to one of the preceding claims, **characterized in that** the solder carrier layer (14) is subjected to at least one treatment, in particular a heat treatment, so that propagation of at least one intermetallic phase (28) in the solder carrier layer (14) is promoted.

9. Method according to one of the preceding claims, **characterized in that** at least some of the metal particles (18) of the paste (16) respectively comprise at least one functional coating (42, 44, 46).

10. Method for connecting a component (38) to a substrate (12) by means of diffusion soldering, comprising the steps:
i. producing and providing a structural unit (10) which comprises the substrate (12) and a solid solder carrier layer (14), which is held on the substrate (12) independently of the component (38) and comprises a paste (16) infiltrated with solder (26);
ii. bringing at least one region (40) to be soldered of the component (38) in contact with the solder carrier layer (14) ;
iii. soldering the substrate (12) to the component (38) via the solder carrier layer (14) by means of diffusion soldering, during which the solder carrier layer (14) is at least partially melted,
**characterized in that** the component (10) is produced by means of a method according to one of Claims 1 to 9.

11. Method according to Claim 10, **characterized in that** the component (10) is a surface-mounted component.

## Revendications

1. Procédé de fabrication d'un module (10) à braser à au moins un composant par brasage par diffusion et constitué indépendamment du composant (38), comprenant les stades :
i. on se procure un substrat (12) du module (10) ;
ii. on dépose une pâte (16), qui a au moins des particules (18) métalliques et des particules (20) de brasure différentes des particules (18) métalliques, sur au moins une région (22) partielle du substrat (12) au moyen d'un technique d'impression ;
iii. on infiltre la pâte (16) par de la brasure (26) en l'absence du composant (38), grâce à quoi la pâte (16) infiltrée par la brasure (26) forme une couche (14) de support de brasure,
**caractérisé en ce que**
- on applique la brasure (26) sous la forme d'au moins une pièce moulée à rigidité propre ; et/ou
- une adaptation de la topographie de surface de la pâte (16) a lieu sur le substrat (12) au moyen d'un poinçon (32).

2. Procédé suivant la revendication 1, **caractérisé en ce que** les particules métalliques sont en cuivre et/ou en fer et/ou en nickel et/ou en argent et/ou en or.

3. Procédé suivant la revendication 1 ou 2, **caractérisé en ce que** l'on traite thermiquement la pâte (16) et/ou la brasure (26) et/ou la couche (14) support de brasure avant et/ou après l'infiltration.

4. Procédé suivant l'une des revendications précédentes, **caractérisé en ce que** l'on applique la brasure (26) avant l'infiltration sur au moins une partie de la pâte (16) et/ou sur au moins une partie (30) du substrat (12) se raccordant à la région (22) partielle et exempte de la pâte (16).

5. Procédé suivant l'une des revendications précédentes, **caractérisé en ce que** l'on utilise comme technique d'impression la technique au pochoir et/ou la sérigraphie.

6. Procédé suivant l'une des revendications précédentes, **caractérisé en ce que** le substrat (12) est au moins une partie d'un support de câblage.

7. Procédé suivant l'une des revendications précédentes, **caractérisé en ce que** l'on dépose un étamage (34) au moins sur une surface (36), loin du substrat (12), de la couche (14) de support de brasure.

8. Procédé suivant l'une des revendications précédentes, **caractérisé en ce que** l'on soumet la couche (14) de support de brasure au moins à un traitement, notamment thermique, grâce à quoi une dissémination d'au moins une phase (28) intermétallique est transportée dans la couche (14) de support de brasure.

9. Procédé suivant l'une des revendications précédentes, **caractérisé en ce qu'**au moins une partie des particules (18) métalliques de la pâte (16) ont chacune au moins un revêtement (42, 44, 46) fonctionnel.

10. Procédé de connexion d'un composant (38) à un substrat (12) au moyen d'un brasage par diffusion, comprenant les stades :
i. production et mise à disposition d'un module (10), qui comprend le substrat (12) et une couche (14) de support de brasure solide maintenue sur le substrat (12) indépendamment du composant (38) et ayant une pâte (16) infiltrée de brasure (26) ;
ii. mise au moins d'une partie (40) à braser du composant (38) en contact avec la couche (14) de support de brasure ;
iii. brasure du substrat (12) au composant (38) par la couche (14) de support de brasure au moyen d'un brasage par diffusion, dans lequel on fait fondre au moins en partie la couche (14) de support de brasure,
**caractérisé en ce que** l'on produit le module (10) au moyen d'un procédé suivant l'une des revendications 1 à 9.

11. Procédé suivant la revendication 10, **caractérisé en ce que** le composant (10) est un composant monté en surface.
